# EUROPÄISCHE PATENTSCHRIFT

(11) **EP 2 807 546 B1**
(45) Veröffentlichungstag und Bekanntmachung des Hinweises auf die Patenterteilung: **29.04.2020**
(21) Anmeldenummer: 13700754.8
(22) Anmeldetag: 21.01.2013
(51) Int. Cl.: G06F 3/05, H03M 1/00, G06F 1/32, G01F 23/14, G01F 1/34, G06F 1/324, H03M 1/12

(54) **ANWENDUNGSSPEZIFISCHER INTEGRIERTER SCHALTKREIS UND EINEN MESSUMFORMER MIT EINEM SOLCHEN SCHALTKREIS**
APPLICATION-SPECIFIC INTEGRATED CIRCUIT AND A MEASURING TRANSDUCER HAVING SUCH A CIRCUIT
CIRCUIT INTÉGRÉ À APPLICATION SPÉCIFIQUE ET CONVERTISSEUR DE MESURE COMPRENANT UN TEL CIRCUIT

(30) Priorität: 23.01.2012 DE 102012001098
(43) Veröffentlichungstag der Anmeldung: 03.12.2014
(73) Patentinhaber: Endress+Hauser SE+Co. KG, 79689 Maulburg (DE)
(72) Erfinder: KARWECK, Lars, 79589 Binzen (DE); SPITZ, Andreas, 79650 Schopfheim (DE); BOULENGER, Yves, 79650 Schopfheim (DE); WAGNER, Richard, 79588 Efringen-Kirchen (DE); WINTER, Klaus, 79585 Steinen (DE); ZIERINGER, Thomas, 79650 Schopfheim (DE)
(74) Vertreter: Andres, Angelika Maria
(86) Internationale Anmeldenummer: PCT/EP2013/051046
(87) Internationale Veröffentlichungsnummer: WO 2013/110570

(56) Entgegenhaltungen:
- DE-A1- 2 939 787
- US-A- 4 638 451

## Beschreibung

Die vorliegende Erfindung betrifft eine elektronische Schaltung, insbesondere einen integrierten Schaltkreis, insbesondere einen anwendungsspezifischen integrierten Schaltkreis und insbesondere einen Messumformer mit einem solchen anwendungsspezifischen integrierten Schaltkreis.

Anwendungsspezifische integrierte Schaltkreise sind an sich bekannt und werden beispielsweise in Messumformern der industriellen Prozessmesstechnik eingesetzt, um beispielsweise einen Sensor mit einem analogen elektrischen Wandler zu betreiben und dessen analoge Primärsignale zu digitalisieren und aufzubereiten sowie Ausgangssignale zu übergeordneten Einheiten bereitzustellen.

Die Offenlegungsschrift DE 2939787 A1 offenbart ein Verfahren und eine Vorrichtung zur Speicherung mindestens einer zeitabhängigen elektrischen Variablen.

Das Patent US 4,638,451 A offenbart ein Mikroprozessorsystem mit programmierbaren Schnittstellen, insbesondere zur Sprachsignalverarbeitung. Hierbei sind eine Signalausgabefrequenz und die Signaleingangsfrequenz veränderlich.

Moderne Messumformer sollen in einer Vielzahl von Einsatzgebieten mit unterschiedlichsten Anforderungen an Messgenauigkeit oder Dynamik funktionieren. Zudem sollen die Komponenten der Messumformer in ihrer Leistungsfähigkeit im Idealfall skalierbar und hinsichtlich des Energieverbrauchs flexibel sein.

Es ist daher eine Aufgabe der vorliegenden Erfindung, eine elektronische Schaltung, insbesondere einen Messumformer bereitzustellen, die bzw. der diesen Anforderungen weitgehend genügt.

Die Aufgabe wird gelöst durch den Messumformer gemäß Anspruch 1. Weiterbildungen des Messumformers sind in den abhängigen Ansprüchen 2 bis 8 definiert.

Die Erfindung wird nun anhand der in den Zeichnungen dargestellten Ausführungsbeispiele näher erläutert. Es zeigt:
- Fig. 1:: eine schematische Darstellung eines ersten Ausführungsbeispiels eines erfindungsgemäßen, anwendungsspezifischen integrierten Schaltkreises (ASICs);
- Fig. 2a:: den zeitlichen Verlauf von Signalen eines ASICs mit festen Frequenzen bzw. Frequenzverhältnissen nach dem Stand der Technik;
- Fig. 2b:: den zeitlichen Verlauf von Signalen eines erfindungsgemäßen ASICs mit variablen Frequenzen bzw. Frequenzverhältnissen;
- Fig. 3:: ein Beispiel für die Steuerung der Taktfrequenz f_{DSP} des digitalen Signalprozessors anhand der zeitlichen Ableitung eines Ausgangssignals SPᵢ;
- Fig. 4a:: eine erste schematische Darstellung eines erfindungsgemäßen Messumformers; und
- Fig. 4b:: eine zweite, detailliertere schematische Darstellung eines erfindungsgemäßen Messumformers.

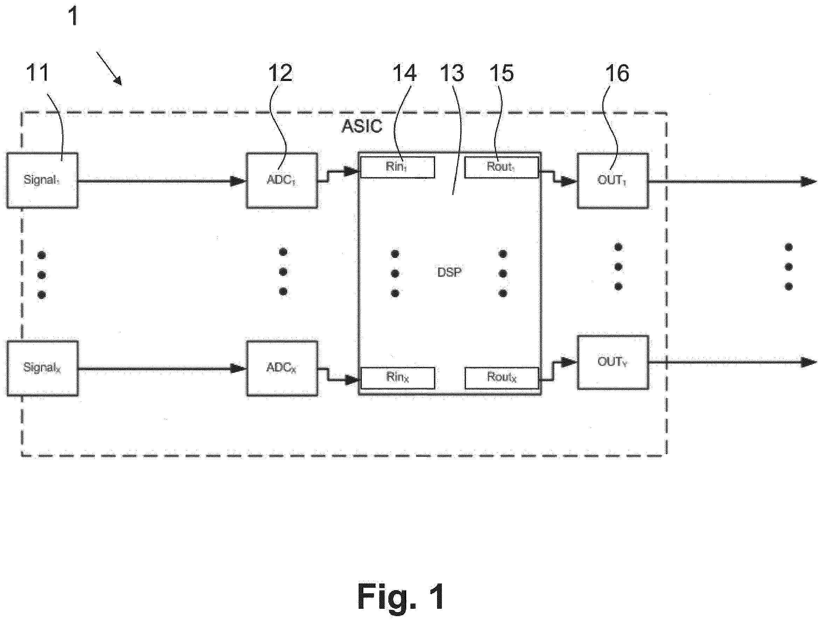

Der in Fig. 1 dargestellte anwendungsspezifische integrierte Schaltkreis (ASIC) 1 umfasst n analoge Signaleingänge 11 an denen beispielsweise die Spannungen und/oder Ströme einer Brückenschaltung eines (piezo-) resistiven Drucksensors, einer Messschaltungen eines kapazitiven Drucksensors, eines Temperatursensors, und/oder eines anderen Messwandlers anstehen.

Die analogen Signale Sᵢ (in Fig. 1 mit Signal₁ bis Signalₓ bezeichnet) werden von Analog-Digital-Wandlern 12 mit Abtastfrequenzen f_{Si} abgetastet und digitalisiert und die digitalisierten Signale SDᵢ werden mit Ausgabefrequenzen f_{SD-out-i} Eingangsregistern (Rin_{1...x}) 14 eines digitalen Signalprozessors 13 bereitgestellt. Die Analog-Digital-Wandler können insbesondere Sigma-Delta-Wandler sein.

Die in den Eingangsregistern bereitgestellten n Signale SDᵢ werden vom Signalprozessor 13 zu m aufbereiteten Signalen SPⱼ verarbeitet und in den Ausgangsregistern (Rout_{1...x}) des digitalen Signalprozessors (DSP) bereitstellt.

Diese Verarbeitung kann beispielsweise die Ermittlung eines Druckmesswerts umfassen, welcher anhand zweier je einen Kapazitätsmesswert repräsentierenden Signale SD₁ ,SD₂ und eines einen Temperaturmesswert repräsentierenden Signals SD₃ mittels eines Kompensationsmodells, dessen Koeffizienten von einem hier nicht gezeigten Speicher bereitgestellt werden, berechnet und in mindestens einem Ausgangsregister 15 als Ausgangssignal SPⱼ bereitstellt.

Andere Formen der Verarbeitung können beispielsweise eine Filterung der eingehenden Signale umfassen.

Der digitale Signalprozessor weist eine Ausgabefrequenz f_{DSP} auf, die beispielsweise 1 kHz oder einige 100 Hz beträgt. Der DSP rechnet beispielsweise in 1,25ms sein komplettes Programm durch, dies umfasst bis zu etwa 400 Befehle. Die Taktfrequenz beträgt dann etwa 300kHz pro Befehl. Bei der langsamsten Taktrate dauert ein Rechenzyklus etwa 160 ms. Die Taktfrequenz pro Befehl beträgt dann nur etwas mehr als 2 kHz.

Aus den Ausgangsregistern werden die Signale mit Ausgangsfrequenzen f_{SP-out-j} ausgegeben bzw. ausgelesen.

Ein Ausgangsregister 15 kann beispielweise von einem Digital-AnalogWandler mit einer hohen Frequenz ausgelesen werden, um eine dichte Folge von Messwerten an einem Analogausgang bereitstellen zu können.

Das Ausgangsregister kann auch mit einer niedrigeren Frequenz als der eines DSP-Zyklus erfolgen.

Ein anderes Ausgangsregister kann beispielsweise einen Schleppzeigerwert betreffen, welcher mit erheblich geringerer Frequenz abgerufen wird.

Erfindungsgemäß ist bzw. sind nun eine oder mehrere der Frequenzen f_{SD-out-i}, F_{DSP}, f_{SP-out-j} veränderlich, und zwar vorzugsweise unabhängig voneinander.

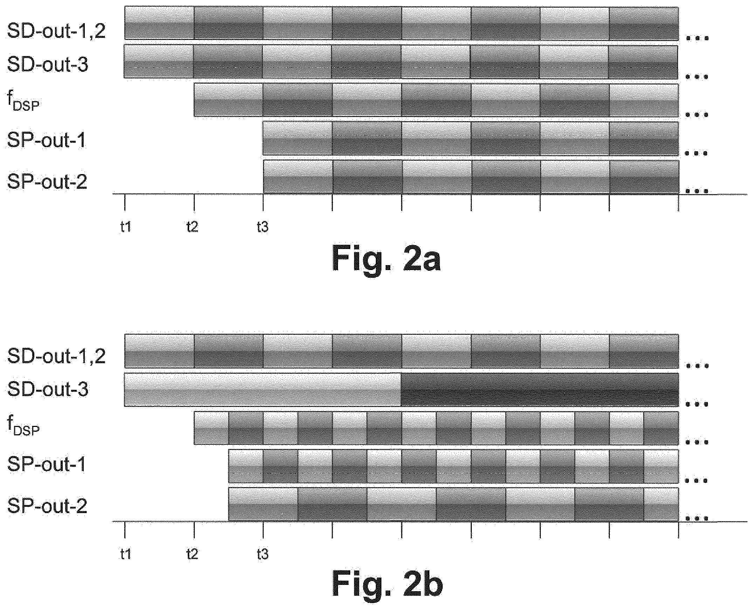

Diese Situation ist in Abgrenzung zum Stand der Technik und Fig. 2a und 2b dargestellt, wobei gemäß Fig. 2a alle genannten Frequenzen im Wesentlichen gleich laufen. Dies führt zu einem vergleichsweise starren System, bei dem Frequenzanpassungen, beispielsweise zur Reduktion der Leistungsaufnahme sich auf alle Leistungsmerkmale des ASICs auswirken. Dagegen sind bei einem erfindungsgemäßen ASIC die Frequenzen an den Bedarf der spezifischen Messsituation angepasst. So können f_{SD-out-1,2} beispielsweise die Ausgaberaten der oben erwähnten digitalisierten Kapazitätsmesswerte sein, während in einem thermisch trägen System die f_{SD-out-3} für die sich langsam ändernden Temperaturmesswerte eher gering ist. Entsprechend kann die Ausgabefrequenz aus den Ausgangsregistern des DSP 13 bedarfsabhängig variieren.

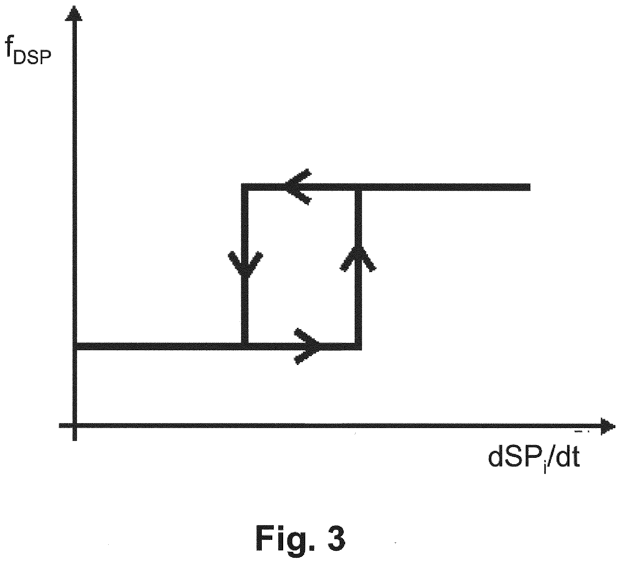

Fig. 3 zeigt nun ein Beispiel für die Steuerung der Taktfrequenz des digitalen Signalprozessors in Abhängigkeit der zeitlichen Ableitung dSPᵢ/dt eines Ausgangssignals SPᵢ des digitalen Signalprozessors. Wenn die zeitliche Ableitung dSPᵢ/dt einen Schwellwert übersteigt, wird die Taktfrequenz um einen konstanten Wert erhöht. Damit die Taktfrequenz jedoch nicht ständig zwischen zwei Frequenzen hin und her springt, wenn die zeitliche Ableitung sich gerade um den Schwellwert bewegt, ist eine Hysterese vorgesehen, wonach die Taktfrequenz erst dann abgesenkt wird, wenn die Ableitung den Schwellwert deutlich unterschreitet. Diese Steuerung der Taktfrequenz des digitalen Signalprozessors kann, je nach Ausgestaltung der Erfindung, vom ASIC selbst oder ggf. von einer übergeordneten Einheit durchgeführt werden.

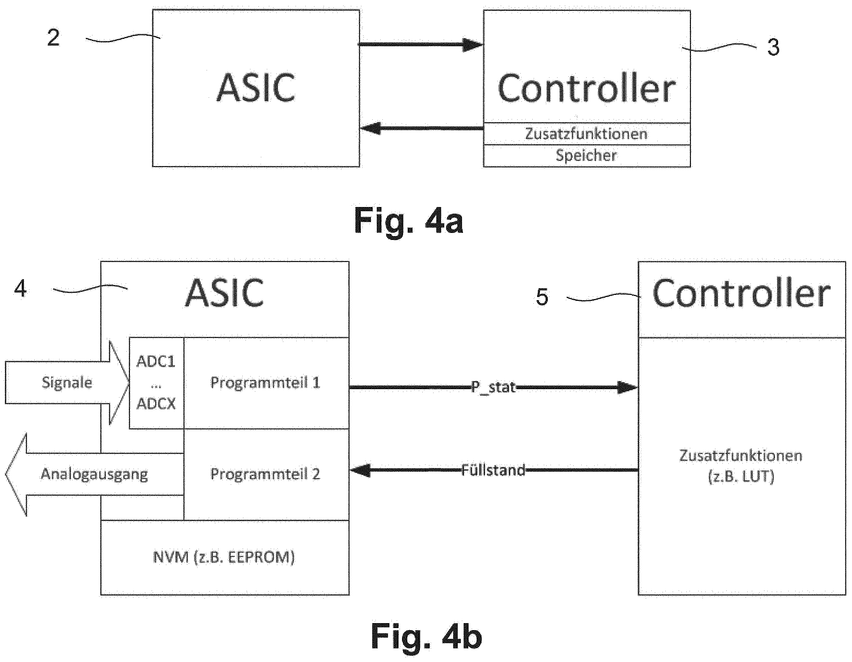

Zur Erläuterung der Beeinflussung der Frequenzen mittels einer übergeordneten Einheit wird nun auf die Figuren 4a und 4b verwiesen.

Fig. 4a zeigt den einfachen Fall eines Messumformers der einen ASIC 2 aufweist, der an einen Controller 3 angeschlossen ist, wobei der Controller 3 zusätzliche Funktionen bei der Auswertung der Signale SPⱼ des DSP des ASIC 2 durchführt. Hier kann er beispielsweise die zeitliche Ableitung dSPⱼ/dt eines Signals SPⱼ ermitteln und daraufhin einen Sollwert für eine oder mehrere der veränderlichen Frequenzen an den ASIC 2 als Antwortsignal ausgeben. Das Antwortsignal kann einen Indexwert aufweisen, wonach der ASIC den Sollwert einem Speicher zu entnehmen hat, oder es kann ein konkreter Frequenzwert übertragen werden.

Fig. 4b zeigt eine detailliertere Darstellung eines Messumformers mit einem ASIC 4 und einem Controller 5. Der ASIC ermittelt mittels seines digitalen Signalprozessors in einem ersten Programmteil einen statischen Druck, dessen Signal p_stat an den Controller 5 übertragen wird. Der Controller hat in einer Tabelle (LUT) beispielsweise ein Profil eines Tanks hinterlegt und kann nun anhand des Drucksignals p_stat das Füllvolumen in m³ bzw. die Masse in t ausrechnen. Das entsprechende Füllstandsignal wird an den ASIC als Antwortsignal übertragen, um beispielsweise über einen zweiten Programmteil des ASIC verarbeitet,und am Analogausgang des ASIC bereitgestellt zu werden.

Der ASIC umfasst weiterhin einen nicht flüchtigen Speicher (NVM) in dem Sollwerte für die veränderlichen Frequenzen als Funktion des Füllstands hinterlegt sind. Der ASIC kann also nun anhand des Antwortsignals vom Controller, welches z.B. den Füllstand repräsentiert die erforderlichen Frequenzanpassungen durchführen, um beispielsweise bei drohenden Grenzwertüber- oder unterschreitungen mit höherer Rate Signale bereitstellen zu können. Beispielsweise zum Pumpenschutz oder zur Überfüllsicherung.

## Patentansprüche

1. Messumformer, umfassend:
einen Controller, und
einen anwendungsspezifischen integrierten Schaltkreis (ASIC)(1),
aufweisend:
n Analogeingänge (11) mit Analog-Digital-Wandlern (ADCi)(12), wobei n > 1, mindestens einen digitalen Prozessor, insbesondere digitalen Signalprozessor (DSP) (13) welcher Eingangsregister (14) und Ausgangsregister (15) aufweist,
wobei die Analog-Digital-Wandler (ADC) Eingangssignale Sᵢ, welche von aktuellen Werten von Messgrößen abhängen, abtasten und digitalisieren und die digitalisierten Signale SDᵢ den Eingangsregistern des digitalen Signalprozessors bereitstellen,
wobei der digitale Signalprozessor (DSP) die digitalisierten Signale SDᵢ zu m aufbereiteten Ausgangssignalen SPⱼ verarbeitet und in den Ausgangsregistern des digitalen Signalprozessors (DSP) bereitstellt, wobei der digitale Signalprozessor eine Taktfrequenz F_{DSP} aufweist,
wobei m >= 1, und j= 1, ..., m,
wobei ferner die Signale SPⱼ von den Ausgangsregistern mit Ausgangsfrequenzen f_{SP-out-j} ausgegeben bzw. ausgelesen werden können,
wobei
der oder die Analog-Digital-Wandler die Eingangssignale Sᵢ, welche von aktuellen Werten von Messgrößen abhängen, (ADC) mit Abtastfrequenzen f_{Si} abtasten, und die digitalisierten Signale SDᵢ mit Ausgabefrequenzen f_{SD-out-i} bereitstellen, und mehrere der Frequenzen f_{SD-out-i}, F_{DSP}, f_{SP-out-j} unabhängig voneinander veränderlich sind, und
der Controller mindestens eins der Ausgangssignale SPⱼ des digitalen Signalprozessors (DSP) empfängt, und in Abhängigkeit des empfangenen Ausgangssignal SPⱼ ein Antwortsignal Sᵣ an den integrierten Schaltkreis ausgibt, wobei mindestens eine der genannten Frequenzen f_{SD-out-i}, F_{DSP}, f_{SP-out-j} des integrierten Schaltkreises in Abhängigkeit des Antwortsignals Sᵣ veränderlich ist.

2. Messumformer nach Anspruch 1,
wobei die eine oder mehrere der Frequenzen f_{SD-out-i}, F_{DSP}, f_{SP-out-j} zumindest von mindestens einem der digitalisierten Messsignale SDᵢ oder einer davon abhängigen Größe abhängt bzw. abhängen.

3. Messumformer nach Anspruch 2, wobei die eine oder mehrere der Frequenzen f_{SD-out-i}, F_{DSP}, f_{SP-out-j} von der zeitlichen Ableitung und/oder einer anderen vom zeitlichen Verlauf des mindestens einen digitalisierten Messsignals SDᵢ abhängigen Funktion abhängt bzw. abhängen.

4. Messumformer nach Anspruch 2, wobei die eine oder mehrere der Frequenzen f_{SD-out-i}, F_{DSP}, f_{SP-out-j} von der Standardabweichung des mindestens einen digitalisierten Messsignals SDᵢ oder einer davon abhängigen Größe abhängt bzw. abhängen.

5. Messumformer nach Anspruch 1, wobei das Antwortsignal Sᵣ ein Steuersignal ist, mit welchem ein Sollwert für mindestens eine der veränderlichen Frequenzen f_{SD-out-i}, F_{DSP}, f_{SP-out-j} des integrierten Schaltkreises vorgegeben wird.

6. Messumformer nach Anspruch 1, wobei das Antwortsignal Sᵣ einen aufbereiteten Messwert umfasst, anhand dessen der integrierte Schaltkreis einen Sollwert der veränderlichen Frequenz f_{SD-out-i}, F_{DSP}, f_{SP-out-j} ermittelt.

7. Messumformer nach Anspruch 1, wobei das Antwortsignal Sᵣ die zeitliche Ableitung eines Messwerts oder dessen Standardabweichung umfasst.

8. Messumformer nach einem der Ansprüche 1 bis 7, wobei der Controller Zusatzfunktionen aufweist, welche beispielsweise die anwendungsspezifische Berechnung einer Füllmenge in einem Tank anhand eines einen hydrostatischen Druck repräsentierenden Signals SPⱼ mittels eines Tankprofils oder die Bestimmung einer Durchflussgeschwindigkeit durch Radizieren eines Differenzdrucksignals umfassen.

## Claims

1. Transmitter, comprising:
a controller, and
an application-specific integrated circuit (ASIC) (1),
comprising
n analog inputs (11) with analog-digital converters (ADCi)(12), where n > 1,
at least a digital processor, particularly a digital signal processor (DSP) (13),
which has an input register (14) and an output register (15),
wherein the analog-digital converters (ADC) scan and digitize input signals Sᵢ, which depend on current values of measured variables, and make the digitized signals SDᵢ available to the input registers of the digital signal processor,
wherein the digital signal processor (DSP) processes the digitized signals SDᵢ into m processed output signals SPⱼ and makes them available in the output registers of the digital signal processor (DSP), wherein the digital signal processor has a clock frequency F_{DSP},
where m >= 1, and j = 1, ..., m,
wherein furthermore the signals SPⱼ can be output and read by the output registers with output frequencies f_{SP-out-j},
wherein the analog-digital converter(s) (ADC) scan(s) the input signals Sᵢ that depend on current values of measured variables at scan frequencies f_{Si} and provide the digitized signals SDᵢ with output frequencies f_{SP-out-j} and many of the frequencies f_{SD-out-i}, F_{DSP}, f_{SP-out-j} can be modified independently of one another, and the controller receives at least one of the output signals SPⱼ of the digital signal processor (DSP), and outputs a response signal Sᵣ to the integrated circuit,
depending on the output signal SPⱼ received, wherein at least one of the frequencies f_{sD-out-i}, F_{DSP}, f_{SP-out-j} of the integrated circuit can be modified depending on the response signal Sᵣ.

2. Transmitter as claimed in Claim 1,
wherein one or more of the frequencies f_{SD-out-i}, F_{DSP}, f_{SP-out-j} depend(s) at minimum on at least one of the digitized measuring signals SDᵢ or a variable that depends on said digitized measuring signal.

3. Transmitter as claimed in Claim 2, wherein one or more of the frequencies f_{SD-out-i}, F_{DSP}, f_{SP-out-j} depend(s) on the time derivative and/or another function that depends on the pattern over time of the at least one digitized measuring signal SDᵢ.

4. Transmitter as claimed in Claim 2, wherein one or more of the frequencies f_{SD-out-i}, F_{DSP}, f_{SP-out-j} depend(s) on the standard deviation of the at least one digitized measuring signal SDᵢ or a variable that depends on said digitized measuring signal.

5. Transmitter as claimed in Claim 1, wherein the response signal Sᵣ is a control signal with which a set value is predefined for at least one of the modifiable frequencies f_{SD-out-i}, F_{DSP}, f_{SP-out-j} of the integrated circuit.

6. Transmitter as claimed in Claim 1, wherein the response signal Sᵣ comprises a processed measured value with which the integrated circuit determines a target value of the modifiable frequency f_{SD-out-i}, F_{DSP}, f_{SP-out-j}.

7. Transmitter as claimed in Claim 1, wherein the response signal Sᵣ comprises the time derivative of a measured value or its standard deviation.

8. Transmitter as claimed in one of the Claims 1 to 7, wherein the controller has additional functions, which comprise, for example, the application-specific calculation of a fill quantity in a tank using a signal SPⱼ representing a hydrostatic pressure, with the aid of a tank profile, or the determination of a flow velocity by extracting the square root of a differential pressure signal.

## Revendications

1. Transmetteur, comprenant :
un contrôleur, et
un circuit intégré (ASIC) (1) spécifique à l'application,
comprenant
n entrées analogiques (11) avec des convertisseurs analogiques-numériques (ADCᵢ)(12), où n > 1,
au moins un processeur numérique, notamment un processeur de signal numérique (DSP) (13), lequel comprend un registre d'entrée (14) et un registre de sortie (15),
les convertisseurs analogiques-numériques (ADC), qui dépendent des valeurs actuelles de grandeurs de mesure, échantillonnant et numérisant les signaux d'entrée Sᵢ, et mettant à la disposition des registres d'entrée du processeur de signal numérique les signaux numérisés SDᵢ,
le processeur de signal numérique (DSP) transformant les signaux numérisés SDᵢ en m signaux de sortie traités SPⱼ et les mettant à disposition dans les registres de sortie du processeur de signal numérique (DSP), le processeur de signal numérique présentant une fréquence d'horloge F_{DSP},
avec m >= 1, et j = 1, ..., m,
les signaux SPⱼ pouvant être sortis ou lus par les registres de sortie avec les fréquences de sortie f_{SP-out-j},
le ou les convertisseurs analogiques-numériques échantillonnant avec les fréquences d'échantillonnage f_{Si} les signaux d'entrée Sᵢ, qui dépendent des valeurs actuelles de grandeurs de mesure, et mettant à disposition les signaux numérisés SDᵢ avec les fréquences de sortie f_{SP-out-j}, et plusieurs des fréquences f_{SD-out-i}, F_{DSP}, f_{SP-out-j} étant modifiables indépendamment les unes des autres, et le contrôleur recevant au moins l'un des signaux de sortie SPⱼ du processeur de signal numérique (DSP), et émettant en fonction du signal de sortie SPⱼ reçu un signal de réponse Sᵣ au circuit intégré, au moins l'une des fréquences f_{SD-out-i}, F_{DSP}, f_{SP-out-j} du circuit intégré étant modifiable en fonction du signal de réponse Sᵣ.

2. Transmetteur selon la revendication 1,
pour lequel l'une ou plusieurs des fréquences f_{SD-out-i}, F_{DSP}, f_{SP-out-j} dépend ou dépendent au minimum d'au moins l'un des signaux de mesure numérisés SDᵢ ou une grandeur en dépendant.

3. Transmetteur selon la revendication 2, pour lequel l'une ou plusieurs des fréquences f_{SD-out-i}, F_{DSP}, f_{SP-out-j} dépend ou dépendent de la dérivée temporelle et/ou d'une autre fonction dépendant de l'évolution temporelle de l'au moins un signal de mesure numérisé SDᵢ.

4. Transmetteur selon la revendication 2, pour lequel l'une ou plusieurs des fréquences f_{SD-out-i}, F_{DSP}, f_{SP-out-j} dépend ou dépendent de l'écart-type de l'au moins un signal de mesure numérisé SDᵢ ou d'une grandeur en dépendant.

5. Transmetteur selon la revendication 1, pour lequel le signal de réponse Sᵣ est un signal de commande, avec lequel une valeur de consigne est prédéfinie pour l'au moins une des fréquences f_{SD-out-i}, F_{DSP}, f_{SP-out-j} modifiables du circuit intégré.

6. Transmetteur selon la revendication 1, pour lequel le signal de réponse Sᵣ comprend une valeur mesurée traitée, au moyen de laquelle le circuit intégré détermine une valeur de consigne de la fréquence f_{SD-out-i}, F_{DSP}, f_{SP-out-j} modifiable.

7. Transmetteur selon la revendication 1, pour lequel le signal de réponse Sᵣ comprend la dérivée temporelle d'une valeur mesurée ou de son écart-type.

8. Transmetteur selon l'une des revendications 1 à 7, pour lequel le contrôleur comprend des fonctions supplémentaires, lesquelles concernent, par exemple, le calcul spécifique à l'application d'une quantité de remplissage dans un réservoir au moyen d'un signal SPⱼ représentant une pression hydrostatique, à l'aide d'un profil de réservoir ou la détermination d'une vitesse d'écoulement par l'extraction de la racine carrée d'un signal de pression différentielle.
